# FASCICULE DE BREVET EUROPEEN

(11) **EP 2 353 184 B1**
(45) Date de publication et mention de la délivrance du brevet: **07.02.2018**
(21) Numéro de dépôt: 09801494.7
(22) Date de dépôt: 03.12.2009
(51) Int. Cl.: H01L 31/0224, H01L 31/18

(54) **MODULE PHOTOVOLTAIQUE COMPRENANT UNE ELECTRODE TRANSPARENTE CONDUCTRICE D'EPAISSEUR VARIABLE ET PROCEDES DE FABRICATION D'UN TEL MODULE**
PHOTOVOLTAIKMODUL MIT TRANSPARENTER LEITENDER ELEKTRODE MIT VARIABLER DICKE UND HERSTELLUNGSVERFAHREN DAFÜR
PHOTOVOLTAIC MODULE INCLUDING A TRANSPARENT CONDUCTIVE ELECTRODE HAVING A VARIABLE THICKNESS, AND METHODS FOR MANUFACTURING SAME

(30) Priorité: 03.12.2008 FR 0858237
(43) Date de publication de la demande: 10.08.2011
(73) Titulaire: École Polytechnique, 91120 Palaiseau (FR); Centre National de la Recherche Scientifique, 75794 Paris Cedex 16 (FR); Total SA, 92400 Courbevoie (FR)
(72) Inventeur: JOHNSON, Erik V., 75020 Paris (FR); ROCA I CABARROCAS, Pere, 91140 Villebon sur Yvette (FR)
(74) Mandataire: Jacobacci Coralis Harle
(86) Numéro de dépôt international: PCT/FR2009/052400
(87) Numéro de publication internationale: WO 2010/063970

(56) Documents cités:
- EP-A- 0 935 296
- WO-A-2005/119796
- DE-A1- 3 606 557
- FR-A- 2 832 706
- US-B1- 6 168 968

## Description

L'invention concerne le domaine technique des cellules photovoltaïques et plus particulièrement celui des électrodes transparentes qui sont un élément nécessaire de ces cellules photovoltaïques.

Les cellules photovoltaïques connaissent un intérêt croissant avec l'amélioration de leur rendement énergétique. Ces cellules photovoltaïques sont basées sur l'utilisation d'un empilement photovoltaïque de matériaux actifs, qui absorbe une énergie optique, par exemple solaire, et la convertit en courant électrique provenant d'une différence de potentiel électrochimique entre les couches actives. L'empilement photovoltaïque peut être formé à l'intérieur d'un matériau massif (plaque de silicium cristallin ou polycristallin) ou grâce à des matériaux déposés en couches minces sur un substrat. La différence de potentiel peut provenir du dopage d'un matériau ou de l'utilisation de différents matériaux. Une cellule photovoltaïque comprend aussi des électrodes des deux côtés de l'empilement photovoltaïque pour collecter le courant électrique ainsi généré et le transporter latéralement aux bords de la cellule. Un module photovoltaïque est formé en reliant plusieurs cellules photovoltaïques en série et/ou en parallèle.

Les électrodes métalliques sont généralement opaques à la lumière visible. On a cependant développé des électrodes à la fois transparentes et conductrices, qui peuvent être placées sur la surface exposée au rayonnement optique d'un empilement photovoltaïque. Pour les cellules en matériau massif, la couche dopée face à la source d'illumination (dans la suite de ce document cette couche est nommée « l'émetteur ») peut être suffisamment conductrice - par exemple si elle est fabriquée en matériau massif dopé - pour transporter les porteurs de charge latéralement sur des distances de l'ordre du millimètre. Ensuite, une grille métallique ajourée est utilisée pour transporter le courant sur le trajet restant jusqu'aux bords de la cellule. Souvent, pour les couches minces, la couche active dopée n'est pas suffisamment conductrice pour effectuer ce transport efficacement et un autre matériau d'électrode à la fois transparent et conducteur est nécessaire. Les matériaux utilisés pour ces électrodes transparentes sont en particulier des oxydes métalliques (TCO pour Transparent Conductive Oxides) qui sont typiquement des oxydes métalliques dopés par un autre élément, tels que l'oxyde d'étain dopé fluor (SnO₂ :F), ou l'oxyde de zinc dopé aluminium (ZnO :Al). Un autre TCO couramment utilisé est l'oxyde d'Indium et d'étain (ITO pour Indium Tin Oxide), qui est hautement conducteur et a une faible rugosité de surface ce qui le rend intéressant pour les écrans plats. Cette faible rugosité de surface rend l'ITO moins intéressant pour les cellules photovoltaïques de type « superstrate », où la lumière incidente traverse un substrat support avant d'entrer dans la cellule. En effet, une rugosité de surface à l'interface entre la couche active et l'électrode avant est recherchée afin d'améliorer la diffusion des photons incidents à l'intérieur du matériau photovoltaïque, et ainsi améliorer leur absorption. Les couches minces actives déposées à partir de précurseurs en phase gazeuse se déposent de manière conforme à la topologie du substrat. La rugosité recherchée doit donc provenir du substrat ou du TCO. L'utilisation d'un TCO lisse dans cette situation est seulement pratique si le substrat est déjà texturé. Par contre, l'oxyde d'étain dopé au fluor (SnO₂:F) donne un dépôt texturé. L'oxyde de zinc dopé aluminium (ZnO:Al) est rugueux lorsqu'il est déposé par dépôt chimique en phase vapeur à faible pression (LPCVD), et lisse lorsqu'il est déposé par pulvérisation, mais sa rugosité peut être augmentée par un traitement chimique ex-situ.

Pour les cellules photovoltaïques obtenues par empilement de couches minces, il existe deux types de structures. Selon un premier type de structure, de type « superstrate », un substrat transparent sert de fenêtre à la cellule photovoltaïque. Dans ce cas, une électrode transparente est déposée sous la forme d'une couche mince d'oxyde transparent conducteur (OTC) sur le substrat transparent (plaque de verre par exemple). L'empilement photovoltaïque et l'électrode arrière sont ensuite déposés successivement selon les procédés connus de dépôt. Selon un second type de structure, de type « substrate », une électrode métallique est déposée sur un substrat (pas nécessairement transparent), puis les couches minces de matériaux photovoltaïques sont déposées par-dessus, et enfin une électrode transparente est déposée par-dessus l'empilement photovoltaïque. La cellule ainsi formée est ensuite encapsulée.

Dans les cellules photovoltaïques à base de matériau photovoltaïque massif, ce matériau sert de substrat, une électrode métallique est déposée sur la face arrière du matériau, et l'émetteur sur la face avant (produit par diffusion thermique d'un dopant ou par implantation ionique) participe au transport latéral des porteurs. Une grille métallique est déposée afin de compléter le circuit conducteur pour les porteurs jusqu'aux électrodes extérieures. Les cellules « HIT - Heterojunction with Intrinsic Thin Layer » représentent un cas particulier, car elles utilisent un matériau massif mais les couches dopées sont déposées à partir de précurseurs en phase gazeuse et ne sont pas suffisamment conductrices. Ce type de cellule doit donc utiliser une couche TCO pour le transport latéral des porteurs, comme dans le cas des cellules à base de couches minces déposées sur un substrat. De plus, les cellules en silicium massif peuvent aussi utiliser une couche de TCO comme couche anti-reflet.

Pour entrer dans une cellule photovoltaïque, quel que soit le type de cellule utilisée, la lumière traverse une fenêtre qui doit remplir deux fonctions : elle doit être aussi transparente que possible pour permettre à un flux maximum de lumière de la traverser, et elle doit être aussi conductrice que possible pour minimiser les pertes ohmiques lorsque le photo courant est collecté. Toutefois, les électrodes transparentes présentent des propriétés électriques inférieures à celles des électrodes métalliques.

Afin d'améliorer la collecte de courant par une électrode transparente, certains dispositifs utilisent une fenêtre comprenant une couche mince d'un d'oxyde transparent conducteur (TCO), utilisée soit seule soit combinée avec une grille métallique. L'utilisation d'une telle grille métallique est par exemple décrite dans le document de brevet CA1244120. Aux emplacements de la cellule qui se rapprochent de la connexion où le courant sera éventuellement extrait, la surface occupée par les doigts de la grille augmente : les doigts y sont plus proches les uns des autres et/ou sont plus larges. La surface occupée par les doigts de la grille devient plus importante, et donc plus de surface de la cellule est masquée par les doigts, cependant l'augmentation obtenue dans la conductivité latérale est nettement avantageuse pour le rendement de la cellule.

Pour les cellules en couches minces, il est courant de n'utiliser qu'une couche de TCO sans grille métallique. Les matériaux TCO couramment utilisés et leurs épaisseurs respectives sont par exemple : SnO₂:F (800nm), ZnO:Al (600nm) et ITO (200nm). ZnO:Al est préférentiellement utilisé dans des applications où la couche mince photovoltaïque est déposée par-dessus la couche de TCO dans des conditions riches en hydrogène, car cette couche de TCO seule est résistante à la réduction par l'hydrogène atomique généré dans le plasma pendant le dépôt. Toutefois, l'absorption dans la couche de ZnO:Al augmente aux grandes longueurs d'onde avec un taux de dopage croissant, comme décrit par Berginski *et al.* (SPIE Photonics 2006), si bien que les contraintes de faible absorption et de faible résistivité sont opposées, au niveau des propriétés mêmes du matériau. Cette contrainte s'ajoute à la contrainte évidente liée au fait qu'une couche plus épaisse a une conduction latérale plus élevée mais aussi une absorption plus élevée. Un compromis doit alors être trouvé entre ces deux propriétés dans la structure d'une cellule ou d'un module photovoltaïque.

Des structures particulières ont été développées pour tenter d'éviter ces inconvénients. Le document WO-A-2005/119796 décrit un module photovoltaïque comprenant plusieurs cellules en série et un procédé de fabrication d'un tel module. Le document EP-A-0935296 décrit un procédé de dépôt par électrolyse en phase aqueuse d'une couche mince d'oxyde de zinc d'épaisseur uniforme. Le brevet US4647711 décrit l'inclusion d'une grille métallique collecteur de courant dans la couche de TCO. Le document WO 2008/005027 décrit une cellule photovoltaïque comprenant une couche conductrice reliée électriquement à une grille d'électrode en utilisant des zones de contact trapézoïdales.

Plus particulièrement pour les cellules à base de tranches de silicium cristallin, le document JP2004214442 décrit une cellule photovoltaïque comprenant une grille métallique de collecteur déposée sur une couche d'ITO d'épaisseur uniforme mais dont le taux de concentration en oxygène varie entre deux valeurs, suivant que la zone de la couche d'ITO est située en dessous de la grille métallique ou non, de manière à ce que les zones qui ne sont pas en dessous de la grille aient un coefficient d'absorption lumineuse inférieur aux zones situées sous la grille. Dans ce cas, l'émetteur est en matériaux massif et cristallin, et donc est suffisamment conducteur pour contribuer à la conduction latérale.

Un autre élément critique dans la fabrication des modules photovoltaïques est l'interconnexion entre les cellules. Une seule cellule fournit à travers ses électrodes une tension proche de la séparation des niveaux de Fermi des deux matériaux dopés dans la cellule (∼1V ou moins) avec un courant proportionnel à sa surface (10 - 30 mA/cm²) et donc relativement élevé (e.g. 10A pour une cellule de diamètre 20cm). La puissance électrique dans cette forme n'est pas suffisante d'un point de vue pratique, donc pour obtenir une tension plus élevée, les cellules sont interconnectées en série pour produire un module. Pour les cellules monolithiques à base de tranches de silicium cristallin, chaque cellule comprend une tranche entière. Les connexions en série pour former un module photovoltaïque sont alors faites en reliant les conducteurs provenant de chaque cellule individuelle. Pour des modules photovoltaïques en couches minces - comme ceux qui utilisent une couche de matériau absorbant en silicium amorphe, silicium microcristallin, un alliage de silicium et germanium soit amorphe ou microcristallin, un alliage à base de cadmium, ou un alliage cuivre, indium, gallium et soufre - les interconnexions entre cellules sont réalisées en suivant des étapes de masquage, dépôt et/ou gravure.

De nombreuses publications décrivent des méthodes d'implémentation optimisées utilisant les techniques de lift-off, d'exposition ou de remplissage par différents matériaux (WO2008074879, WO2008038553, WO2008016042, US2001037823) ainsi que les étapes de gravure laser (JP2002280580, US5981864, EP0422511). D'autres documents décrivent des modules dans lesquels les cellules sont connectées en parallèle (US6011215, CA1227861, US4652693, US4745078).

Les cellules et modules photovoltaïques en couches minces disponibles sur le marché utilisent généralement une couche d'Oxyde Transparent Conducteur de haute qualité dont l'épaisseur, la transparence et la conductivité électrique sont uniformes sur la surface d'une cellule. Toutefois, le rendement photovoltaïque de ces cellules n'est pas optimum. Les interconnexions et les distances entre ces interconnexions sont optimisées pour tenir compte du fait qu'aucun courant n'est généré dans une interconnexion. De ce point de vue, la distance entre interconnexions doit être maximisée. En revanche, une grande distance entre interconnexions provoque une plus grande résistance série due à la couche de TCO. L'utilisation d'une couche uniforme de TCO conduit ainsi à une solution unique pour la distance optimum entre interconnexions.

La présente invention sort du cadre de l'hypothèse d'une couche homogène de TCO. Au contraire, selon l'invention on utilise les caractéristiques optimales d'un TCO variables en fonction de la position dans cette couche de TCO. L'invention concerne plus particulièrement un module photovoltaïque comprenant au moins deux cellules photovoltaïques en série, chaque cellule étant de forme rectangulaire et comprenant respectivement une électrode arrière en couche mince, un empilement d'au moins deux matériaux actifs photovoltaïques compris entre l'électrode arrière et une seconde électrode transparente conductrice (TC) en couche mince, ladite électrode TC étant apte à collecter et à transmettre un courant électrique généré par l'empilement photovoltaïque, et les deux cellules photovoltaïques étant reliées électriquement en série par une bande de contact électrique s'étendant le long d'un côté adjacent aux deux cellules et comprise entre l'électrode TC de la première cellule et l'électrode arrière de la seconde cellule. Selon l'invention, l'épaisseur locale de l'électrode transparente en couche mince de la cellule varie en fonction de la distance à la bande de contact électrique.

Avantageusement, les propriétés optoélectroniques de l'électrode transparente en couche mince varient en fonction de la distance à ladite bande de contact électrique.

Selon un premier mode de réalisation, l'épaisseur locale et/ou les propriétés optoélectroniques de l'électrode transparente en couche mince d'une cellule décroîssent linéairement à partir de la bande de contact suivant une direction dans le plan de ladite électrode transparente en couche mince.

Selon un second mode de réalisation, l'épaisseur locale (e) et/ou les propriétés optoélectroniques de l'électrode transparente en couche mince d'une cellule décroîssent de manière non linéaire à partir de la bande de contact suivant une direction dans le plan de ladite électrode transparente en couche mince.

Avantageusement, la première électrode est métallique. Avantageusement, le matériau de l'électrode TC est un oxyde transparent conducteur parmi l'oxyde d'étain dopé au fluor (SnO₂:F), l'oxyde de zinc dopé aluminium (ZnO:Al) ou un alliage d'oxydes métalliques, par exemple l'oxyde d'indium et d'étain (ITO).

Selon un mode de réalisation, le module photovoltaïque de l'invention comprend une série de cellules photovoltaïques identiques déposées sur un même substrat, l'empilement photovoltaïque de matériaux actifs comprend du silicium amorphe (a-Si :H) (dopé ou intrinsèque).

L'invention concerne également différents procédés de fabrication d'un module photovoltaïque comprenant une série de N cellules photovoltaïques de formes rectangulaires de largeur L.

Selon un premier procédé de dépôt, la couche mince transparente conductrice d'épaisseur variable d'une série de N cellules d'un module photovoltaïque est déposée sur un substrat par pulvérisation cathodique d'un matériau TC à travers un masque semi-transparent comprenant N dents de scies de largeur L, tout en appliquant, pendant la pulvérisation, une translation relative entre le masque et le substrat dans la direction des dents de scie.

Selon un second procédé de dépôt, la couche mince transparente conductrice d'épaisseur variable est déposée par pulvérisation cathodique d'un matériau TC à travers deux masques comprenant une série de N fentes de largeur L et N zones écran de largeur L, lesdits masques étant séquentiellement mobiles en translation dans deux directions opposées.

Selon un autre procédé de fabrication, la couche mince transparente conductrice d'épaisseur variable est déposée sur un substrat par décomposition thermique d'un précurseur gazeux (ou dépôt chimique en phase vapeur) à travers un masque comprenant N dents de scies de largeur L, tout en appliquant pendant la décomposition thermique, une translation relative entre ledit masque et ledit substrat dans la direction des dents de scie.

Selon un autre procédé de fabrication, le procédé comprend une étape de dépôt uniforme d'une couche mince transparente conductrice et une étape de gravure chimique en phase liquide de ladite couche mince TC par application de ladite couche uniforme sur le bord supérieur d'une cuve comprenant N bacs de gravure et pour chaque bac des moyens de remplissage et de vidange d'un liquide apte à graver le matériau transparent conducteur et des moyens d'étanchéité entre chaque bac. Selon ce procédé, le bord supérieur des bacs forme un plan incliné par rapport au niveau horizontal du liquide dans lesdits bacs de manière à ce que le remplissage et la vidange progressive des bacs soient aptes à graver de manière non uniforme la couche transparente conductrice.

Selon encore un autre procédé de fabrication, le procédé comprend une étape de dépôt uniforme d'une couche mince transparente conductrice et une étape de gravure chimique en phase liquide de ladite couche mince par application de ladite couche uniforme sur le bord supérieur d'une cuve comprenant N bacs de gravure comprenant des moyens communs de remplissage et de vidange d'un liquide apte à graver le matériau transparent conducteur et des moyens d'échappement de l'air de chaque bac. Selon ce procédé, le bord supérieur des bacs forme un plan incliné par rapport au niveau horizontal du liquide dans lesdits bacs de manière à ce que l'échappement progressif de l'air desdits bacs soit apte à graver de manière non uniforme la couche transparente conductrice.

Selon encore un autre procédé de fabrication, le procédé comprend une étape de dépôt d'une couche mince transparente conductrice et une étape d'exposition de ladite couche mince transparente conductrice à un faisceau lumineux intense, tel qu'un faisceau laser, comprenant au moins une longueur d'onde absorbée par ladite couche mince transparente conductrice.

Selon encore un autre procédé de fabrication, le procédé comprend une étape de dépôt d'une couche supplémentaire adjacente à la couche mince transparente conductrice et une étape d'exposition de ladite couche adjacente à un faisceau lumineux intense, tel qu'un faisceau laser, comprenant au moins une longueur d'onde absorbée par ladite couche adjacente de manière à transférer l'énergie absorbée par la couche adjacente à ladite couche mince transparente conductrice.

Cette description est donnée à titre d'exemple non limitatif et fera mieux comprendre comment l'invention peut être réalisée en référence aux dessins annexés sur lesquels :
- la figure 1 représente schématiquement un module photovoltaïque selon l'invention, vu en coupe (figure 1A) et de dessus (figure 1B) ;
- la figure 2 représente schématiquement les propriétés optiques et électriques d'une couche transparente conductrice de cellule photovoltaïque ;
- la figure 3A représente schématiquement un 1^{er} mode de réalisation d'une série de cellules photovoltaïques ayant une variation continue de l'épaisseur de la couche transparente conductrice (les autres couches des cellules ne sont pas représentées) ; la figure 3B représente schématiquement un 2^{nd} mode de réalisation d'une série de cellules photovoltaïques ayant une variation discontinue de l'épaisseur de la couche TC ; les figures 3C et 3D illustrent respectivement la variation spatiale des propriétés optoélectroniques de ce 1^{er} et de ce 2^{nd} mode de réalisation ;
- les figures 4A-4E représentent schématiquement un premier procédé de dépôt par pulvérisation avec un masque indenté et/ou substrat mobile à différentes étapes du procédé de dépôt en vue de côté (Fig 4A), de dessus (4B), dans différentes plans de coupe (4C), en perspective (4D) et de dessus avec un autre masque (4E) ;
- les figure 5A-5F représentent schématiquement un second procédé de dépôt par pulvérisation avec deux masques mobiles suivant une séquence illustrée Figures 5C-5D-5E-5F;
- la figure 6 représente une vue de trois-quarts d'une cuve pour un premier procédé de gravure chimique en phase liquide d'un module photovoltaïque ;
- les figures 7A-7D représentent schématiquement les étapes d'un premier procédé de gravure chimique en phase liquide d'un module photovoltaïque selon l'invention ;
- la figure 8 représente une vue de trois-quarts d'une cuve pour un second procédé de gravure chimique en phase liquide d'un module photovoltaïque ;
- les figures 9A-9E représentent schématiquement les étapes d'un second procédé de gravure chimique en phase liquide d'un module photovoltaïque selon l'invention.

L'invention concerne un module photovoltaïque comprenant des cellules PV en série, chaque cellule comprenant une électrode transparente conductrice (TC) en couche mince. L'invention concerne également différents procédés de fabrication d'une telle couche TC pour module photovoltaïque.

L'invention concerne premièrement une couche transparente et conductrice (TC) pour un module photovoltaïque.

Dans un module comprenant une cellule unique, la couche conductrice TC sert à la fois de fenêtre et d'électrode. Dans un module photovoltaïque comprenant plusieurs cellules reliées en série, la couche TC est reliée électriquement à un contact sur l'électrode arrière de la cellule suivante.

Le matériau de contact avant est de préférence indiqué comme étant un matériau transparent conducteur (TC) plutôt qu'un oxyde transparent conducteur (TCO), car le fait qu'il s'agisse d'un oxyde n'est pas essentiel pour l'invention. Une couche TC qui ne serait pas un oxyde - par exemple une couche métallique très fine - bénéficierait également des caractéristiques de l'invention.

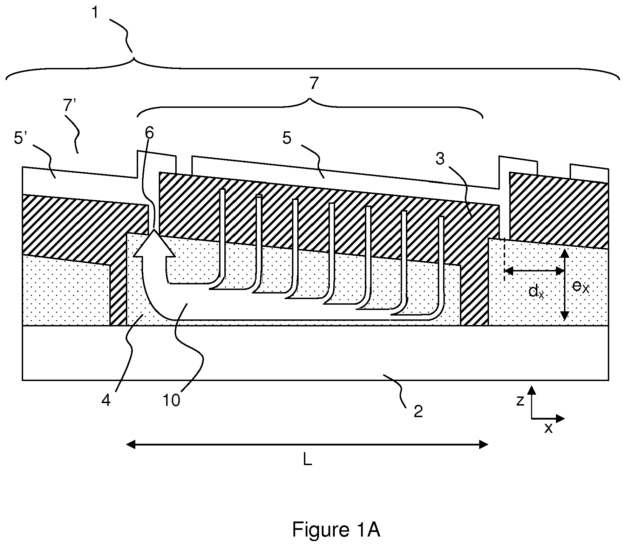

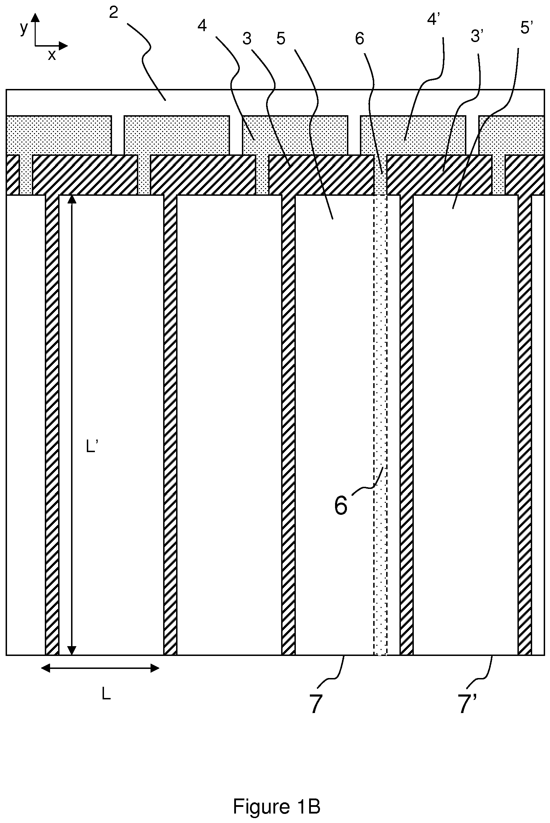

La figure 1A représente un schéma en coupe d'un module photovoltaïque 1 comprenant plusieurs cellules photovoltaïques 7, 7'... selon l'invention, tandis que la figure 1B représente schématiquement ce module 1 en vue de dessus. Les cellules photovoltaïques 7 et 7' sont dans l'exemple représenté déposées sur un même substrat 2 et reliées électriquement entre elles en série. Une cellule photovoltaïque 7 comprend une couche 4 d'un matériau TC déposé sur le substrat 2, un empilement 3 de matériaux photovoltaïques déposé sur la couche de TC 4, et une électrode métallique 5. Les cellules sont reliées entre elles par des interconnexions formées par une bande de contact électrique 6 entre l'électrode TC 4 d'une cellule 7 et l'électrode arrière 5' métallique de la cellule suivante 7'. Le substrat 2 est un substrat plat situé dans un plan XY d'un repère XYZ. La figure 1B montre par transparence la bande de contact 6, cette bande 6 s'étend sur toute la longueur L' d'une cellule 7.

La couche 4 TC de la cellule photovoltaïque de la figure 1A a une épaisseur non uniforme à travers sa surface. Plus précisément l'épaisseur e de la couche TC est maximum au niveau de l'interconnexion 6 et diminue en fonction de la distance dₓ à cette interconnexion.

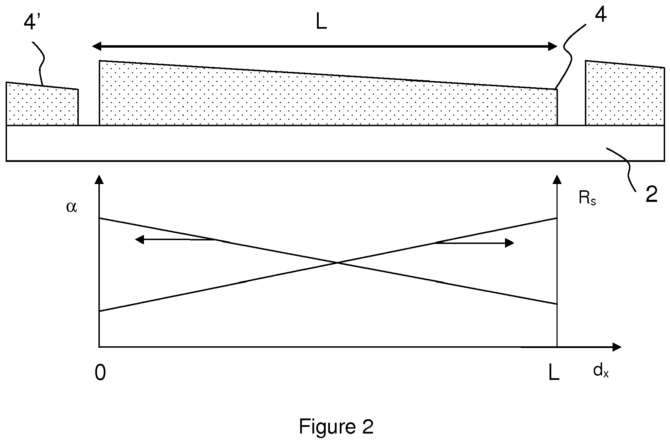

Cette structure de la couche 4 TC permet d'obtenir un compromis entre les propriétés optiques et électriques de la couche 4. En effet, les propriétés de la couche 4 TC varient avec la position par rapport à l'interconnexion dans le module, comme indiqué schématiquement sur la Figure 1A. A proximité de l'interconnexion, les courants électriques (10) générés par le matériau photovoltaïque et collectés par l'électrode transparente conductrice (représentés par des flèches) dans la cellule s'ajoutent et l'épaisseur relativement plus importante de la couche TC permet d'accroître sa conductance (ou de diminuer sa résistance de couche Rₛ). Au contraire, loin de l'interconnexion, moins de courant circule, l'épaisseur de la couche 4 étant plus faible, sa transparence est améliorée, ce qui permet de maximiser la collection de lumière. Ce double effet est schématiquement représenté sur la Figure 2. La figure 2 représente un schéma en coupe d'une couche TC dont les propriétés optiques (absorption α) et électriques (Rₛ) varient sur la largeur L d'une cellule photovoltaïque. Dans ce schéma, les propriétés optoélectroniques de la couche 4 varient avec la position. Les variations d'épaisseur locale et/ou des propriétés opto-électroniques de la couche électrode transparente conductrice 4 permettent d'optimiser le compromis entre conductivité et transparence.

L'invention concerne également différents modes de réalisation de couches de TC pour module photovoltaïque, la couche TC de chaque cellule d'un module ayant une épaisseur et/ou des caractéristiques optoélectroniques non uniformes par rapport à une zone de contact électrique d'interconnexion entre cellules reliées en série.

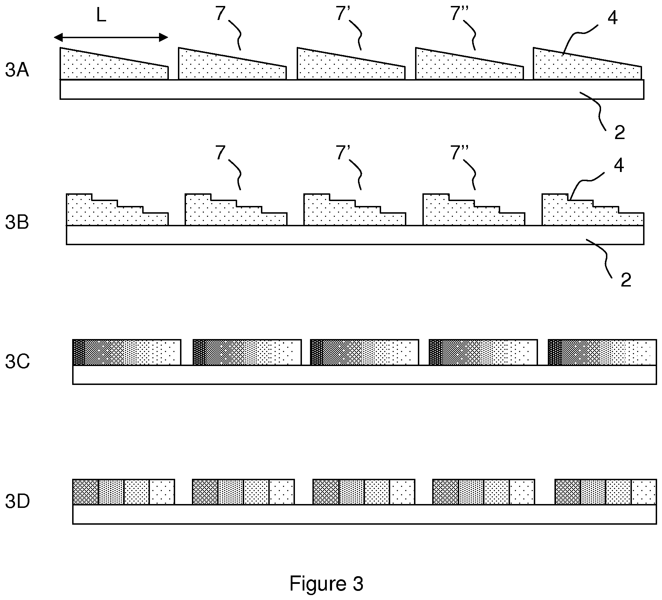

Les figures 3A et 3B représentent schématiquement en coupe deux modes de réalisation de cette non uniformité d'épaisseur de la couche 4 TC. Suivant un premier mode de réalisation (Figure 3A), la variation d'épaisseur de la couche 4 est une variation continue de l'épaisseur de la couche par rapport au point d'interconnexion de chaque cellule. Dans le premier mode de réalisation, les variations de l'épaisseur dans la direction perpendiculaire au plan de la page ne présentent aucun avantage, mais peuvent exister. Ce premier mode de réalisation correspond à une variation continue des propriétés du matériau TC, illustrée schématiquement Fig 3C.

Suivant un second mode de réalisation (Figure 3B), la variation d'épaisseur de la couche 4 est une variation graduelle ou discontinue par marches d'épaisseur constante. Dans ce second mode de réalisation, les variations de l'épaisseur dans la direction perpendiculaire au plan de la page ne présentent aucun avantage, mais peuvent être présent. Ce second mode de réalisation correspond à une variation discontinue des propriétés du matériau TC, illustrée schématiquement Fig 3D.

D'autres profils de variation d'épaisseur de la couche TC peuvent avantageusement être utilisés afin d'optimiser les propriétés du module photovoltaïque.

L'invention concerne également différents procédés de fabrication de couches de TC d'épaisseur non uniforme pour module photovoltaïque. Les procédés décrits visent à modifier l'épaisseur locale d'une couche TC de cellule photovoltaïque plutôt que ses propriétés physiques intrinsèques. Les techniques décrites n'excluent pas l'utilisation d'une étape supplémentaire de séparation électrique des électrodes, par exemple, par gravure laser.

Une première catégorie de procédé de fabrication de couche TC pour module photovoltaïque concerne des procédés de dépôt.

Une technique de dépôt couramment utilisée est la pulvérisation d'un matériau cible 11 sur un substrat 2. Dans le cas de cellules à base d'une tranche de silicium cristallin ou polycristallin, cette tranche sert de substrat au dépôt de l'électrode TC. Dans le cas de cellules en couches minces en configuration substrate, la couche TC est déposée sur les couches actives, les couches actives étant préalablement déposées sur le substrat.

Nous proposons différents procédés de pulvérisation permettant d'obtenir directement une couche TC ayant un profil d'épaisseur recherché.

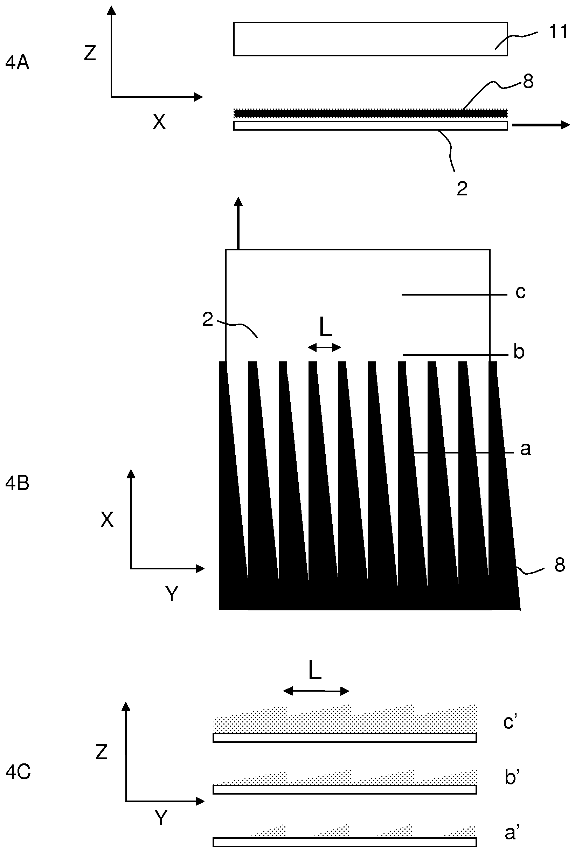

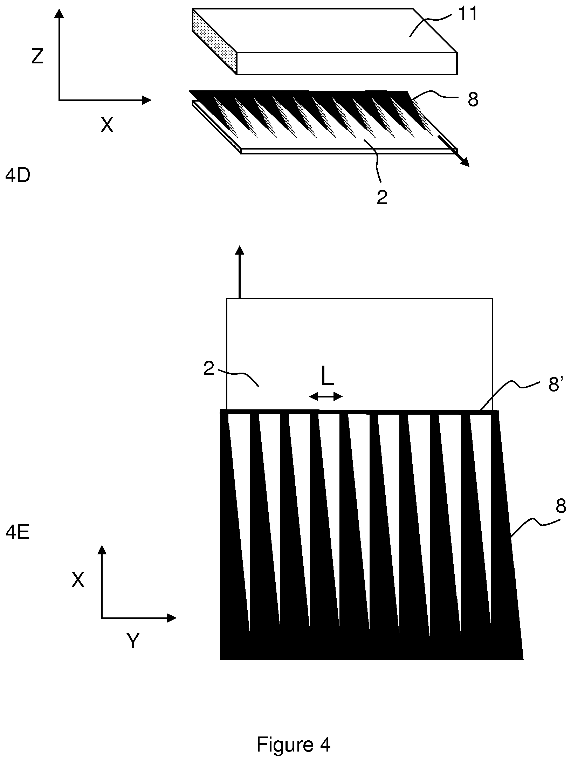

Dans un 1^{er} procédé de pulvérisation continue, où le substrat 2 est mobile pendant le dépôt, nous utilisons un masque 8, dont une vue de coté est présentée fig 4A. Le masque a la forme de dents de scie, où l'espacement entre deux dents correspond à la largueur L d'une cellule photovoltaïque (fig 4B). Un coté de chaque dent est plat pour bien définir la séparation entre deux cellules. Le masque peut être en métal mince, et les extrémités des dents peuvent être autosupportées (vue de dessus, Fig 4B) ou supportées par une barre latérale 8' (fig. 4E), ce qui dépend de la rigidité et des dimensions du masque. Comme le substrat est mobile en translation dans la direction X pendant le dépôt, la surface est exposée graduellement, la couche 4 est déposée uniquement sur la surface exposée, et un profil d'épaisseur variable suivant une direction est obtenu. Une vue en section du profil du matériau (a', b', et c') déposé en trois endroits (a, b, et c) c'est-à-dire à trois instants du procédé, est présentée sur la figure dans Fig. 4C. Le mouvement relatif du substrat par rapport au masque 8 est préférentiellement continu pour que les variations dans l'épaisseur de la couche 4 TC soient présentes dans une direction seulement. Avec un mouvement continu, le motif du masque se reproduit dans l'épaisseur de la couche déposée ; un motif comprenant des triangles droits produit une variation linéaire dans l'épaisseur (figure 3A), un motif comprenant des courbes produit une variation non linéaire, et un motif discontinu produit un profil d'épaisseur discontinu, comme par exemple représenté sur la figure 3B. Ce procédé est également utile dans un mode de réalisation où le masque est mobile en translation.

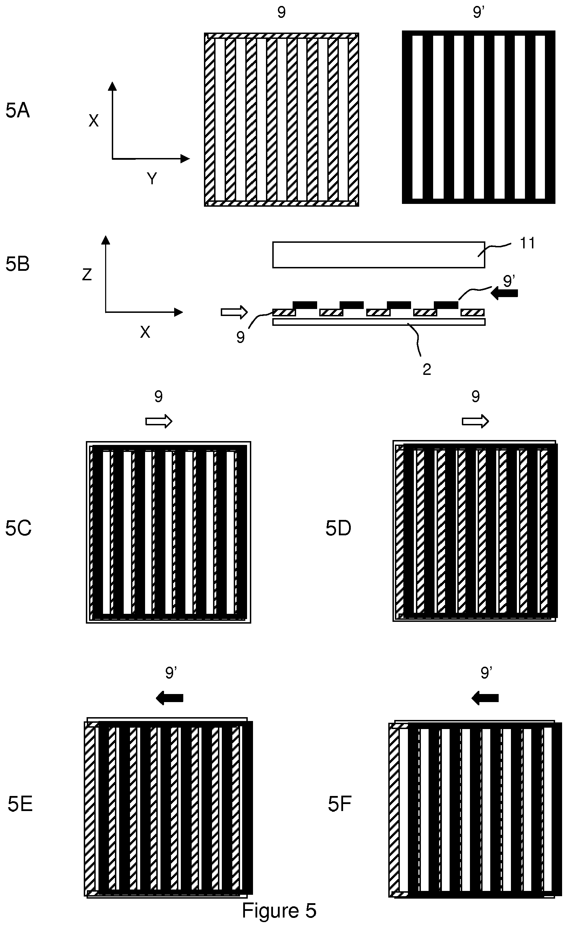

Dans un 2^{ème} procédé de pulvérisation stationnaire, où le substrat est fixe pendant le dépôt, une autre technique de masquage est proposée, qui utilise deux masques complémentaires 9 et 9' comme représentés sur la Fig 5B. Chaque masque 9, 9' comprend des ouvertures dont la largeur correspond à la largeur L d'une cellule photovoltaïque, et des zones de masquage de largeur L identique. La surface des masques 9 et 9' couvre la surface d'un module photovoltaïque. Les masques 9 et 9' sont initialement placés de manière à ce que les ouvertures des masques 9 et 9' coïncident. Pendant la pulvérisation de la couche 4 de TCO, le premier masque 9 est déplacé dans une direction jusqu'à ce que les ouvertures des masques 9 et 9' ne se superposent plus (séquence 5C-5D). Ensuite, le second masque 9' est déplacé dans la direction opposée, jusqu'à ce que les ouvertures des masques 9 et 9' coïncident à nouveau (séquence 5E-5F). Ce procédé permet de produire des couches 4 TC d'épaisseur variable suivant la direction de déplacement des masques 9 et 9'. Dans ce procédé, la vitesse de déplacement des masques détermine le profil en épaisseur de la couche résultante - une vitesse constante produit un profil linéaire, une vitesse variable produit un profil non linéaire, et des arrêts produisent un profil avec des discontinuités en épaisseur.

Une seconde catégorie de procédé de fabrication concerne des procédés de gravure du matériau TC après dépôt.

Une technique couramment utilisée pour graver et texturer certaines couches de TC est un traitement chimique en phase aqueuse. Par exemple, l'utilisation d'une solution diluée de HCl (0.5%) grave le ZnO avec une vitesse de gravure d'environ 60 À/s. La durée d'exposition au mélange aqueux 18 détermine la durée de la gravure. Toutefois, la gravure est généralement uniforme sur toute la surface exposée à la solution. L'invention propose deux procédés de gravure en phase liquide, qui utilisent des cuves de gravure différentes, pour fabriquer simultanément plusieurs cellules photovoltaïques 7, les couches 4 TC ayant un profil d'épaisseur variable par rapport à une zone ou une bande de contact électrique 6, comme décrit plus haut.

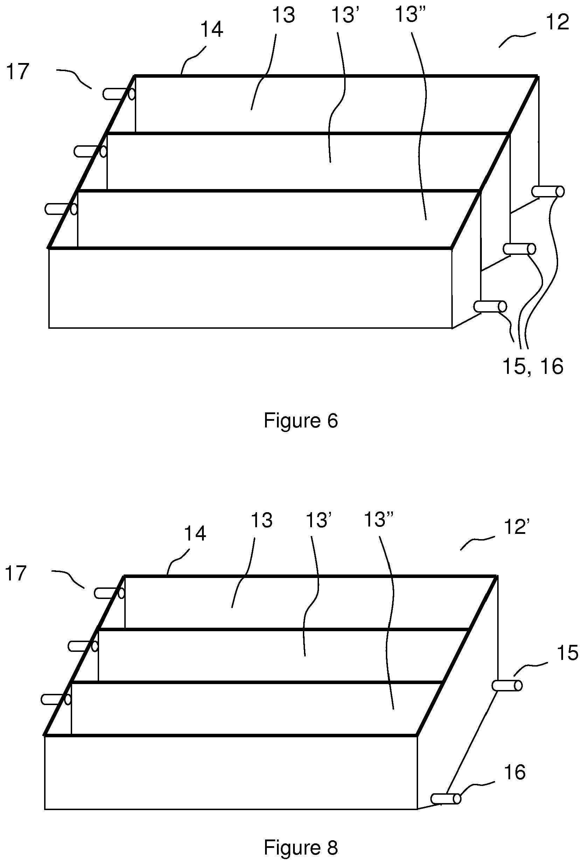

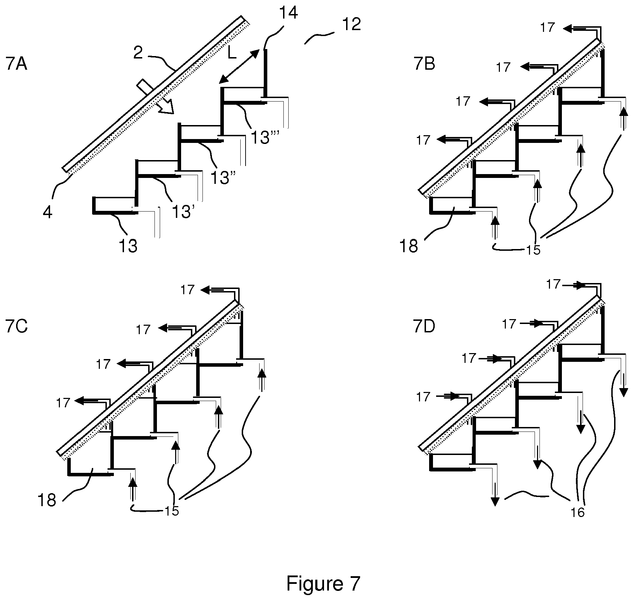

Une première structure de cuve de gravure 12 est représentée schématiquement Figure 6. La cuve 12 comprend une série de bacs 13, 13', 13", dont le nombre correspond au nombre de cellules d'un module photovoltaïque. Le bord supérieur 14 de chaque bac 13, 13', 13" forme un rectangle incliné par rapport au fond horizontal du bac. L'ouverture rectangulaire d'un bac correspond à la surface d'une cellule et est étanche. Les bacs 13, 13', 13" sont reliés de telle manière à ce que le bord supérieur d'un bac corresponde au bord inférieur du bac suivant (Figure 7A). Les fonds des bacs sont décalés les uns par rapport aux autres (Figure 7A). Chaque bac a au moins deux connexions de fluides : une connexion de remplissage 15 et vidange 16 en bas du bac et une connexion 17 pour l'échappement de l'air aussi proche que possible du haut du bac.

Un 1^{er} procédé de gravure aqueux utilisant la cuve 12 de la figure 6 est illustré sur les Figures 7A-7D. Le substrat 2 sur lequel est déposée une couche 4 TC d'épaisseur uniforme est placé sur la cuve 12 de manière à avoir un contact étanche tout autour du substrat et entre chaque bac (Figures 7A-7B). Les bacs 13, 13', 13" sont ensuite remplis simultanément et progressivement avec la solution aqueuse 18 (Figure 7C). La solution18 étant en contact sur une durée plus longue dans la partie inférieur de chaque bac, la gravure de la couche 4 est plus importante à ce niveau qu'en regard de la partie supérieure de chaque bac. Ceci peut être réalisé en retirant un volume d'air fixe de chaque bac à travers la sortie échappement d'air 17. La vitesse à laquelle les bacs se remplissent détermine la gravure relative aux différents points de la surface exposée à la solution aqueuse (Figure 7C), et peut être utilisé pour maîtriser le profil du TC. Les bacs sont ensuite vidés simultanément (Figure 7D), pour permettre de retirer le substrat texturé et gravé ainsi réalisé. Le remplissage et la vidange simultanés des bacs 13, 13', 13" permettent d'obtenir un profil de gravure identique pour chaque cellule du module sur un même substrat 2.

Une seconde structure de cuve de gravure 12' est représentée sur la Figure 8 et comprend également une série de bacs 13, 13', 13" reliés entre eux. Le pourtour rectangulaire qui définit le bord 14 d'un bac est là encore incliné par rapport au fond du bac. La cuve 12' a une seule connexion fluidique de remplissage 15 et une seule connexion de vidange 16, et chaque bac 13, 13', 13" a une connexion d'entrée-sortie 17 pour l'échappement de l'air aussi proche que possible du haut de chaque bac.

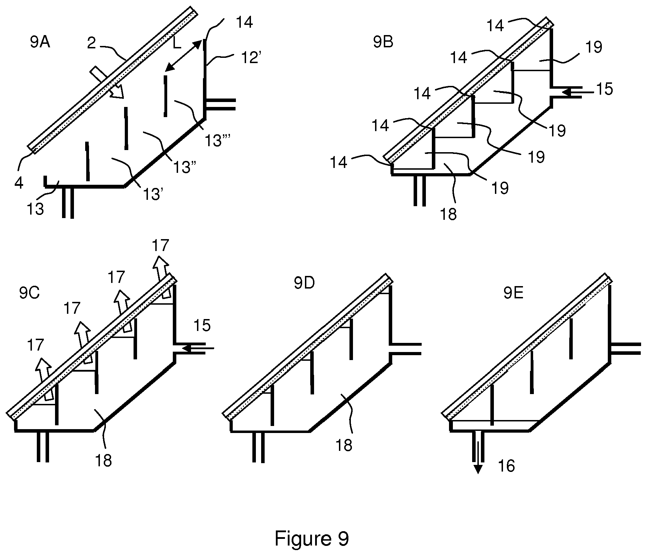

Un 2^{nd} procédé de gravure aqueux utilisant la cuve 12' de la figure 8 est illustré sur les Figures 9A-9E afin d'obtenir un profil comme décrit en 1^{ère} partie. Un module photovoltaïque 1 comprenant un substrat 2 et une couche 4 TC d'épaisseur initialement uniforme est placé sur le bord 14 de la cuve 12' de manière jointive et étanche autour du substrat et entre chaque bac. Les bacs 13, 13', 13" interconnectés sont remplis simultanément avec la solution aqueuse 18 à travers la connexion de remplissage 15 (Fig 9B), bien qu'un remplissage complet soit empêché par l'air emprisonné 19 dans chaque bac, ce qui prévient toute gravure incontrôlée de la surface de la couche 4 pendant cette étape. L'air emprisonné 19 est retiré simultanément et progressivement de tous les bacs (Fig 9C-9D), permettant ainsi à la solution de gravure 18 d'entrer en contact avec la couche TC et de la graver en surface. Après gravure, la solution est retirée par le "drain" (Fig 9D). Ainsi, la vitesse à laquelle les bacs sont remplis et vidés détermine la quantité relative de matériau gravé localement à la surface de la couche de TC de chaque cellule du module photovoltaïque, et peut donc être utilisé pour maîtriser le profil final du TC. Le remplissage et la vidange simultanés des bacs permettent ainsi d'obtenir un profil de gravure identique sur toutes les cellules d'un même module photovoltaïque.

La structure d'une électrode transparente conductrice pour cellule photovoltaïque de l'invention comprend une couche 4 de TC d'épaisseur et/ou de propriétés optoélectroniques variables en fonction de la distance dₓ à une zone ou un point de contact électrique 6 de cette couche 4. Cette zone de contact 6 peut être une connexion entre la couche de TCO 4 et une électrode extérieure pour extraire le courant de la cellule ou une interconnexion entre la couche de TCO d'une première cellule 7 et une électrode métallique d'une seconde cellule 7' en série avec la première cellule 7 dans le module photovoltaïque 1. Les variations d'épaisseur et/ou de propriétés optoélectroniques sont choisies pour améliorer la transparence optique de la couche de TCO où la densité de courant est faible et améliorer les propriétés conductrices de la couche de TCO où la densité de courant est forte, de manière à optimiser le rendement global d'un module photovoltaïque.

Selon un autre procédé de fabrication, la couche mince transparente conductrice de propriétés opto-électroniques variables peut être obtenue par un procédé de recuit laser consistant à exposer une couche mince transparente conductrice ayant des propriétés opto-électroniques uniformes à un faisceau laser comprenant une longueur d'onde susceptible d'être absorbée par le matériau TC. Une exposition sélective de certaines zones de la couche TC permet ainsi d'obtenir une couche TC de propriétés opto-électroniques variables en fonction de la durée d'exposition et/ou de l'intensité locale du faisceau laser.

Selon une variante de ce mode de fabrication, le procédé comprend une étape de dépôt d'une couche supplémentaire adjacente à la couche mince transparente conductrice. On entend ici par couche adjacente soit une couche déposée à l'intérieur de la couche mince transparente conductrice (en sandwich), soit une couche déposée entre la couche mince transparente conductrice 4 et le substrat 2, soit encore une couche déposée entre la couche mince transparente conductrice 4 et l'empilement photovoltaïque de matériaux actifs 3. Selon cette variante, l'exposition de cette couche adjacente à un faisceau laser intense comprenant au moins une longueur d'onde absorbée par ladite couche adjacente permet de transférer l'énergie absorbée par la couche adjacente à ladite couche mince transparente conductrice pour produire une couche TC de propriétés opto-électroniques variables.

Un module photovoltaïque de l'invention peut être réalisé suivant divers procédés de fabrication de dépôt et/ou de gravure. En particulier, l'invention propose des procédés de dépôt de la couche transparent conductrice (TC) et des procédés de gravure après le dépôt permettant de fabriquer simultanément plusieurs cellules d'un même module. Les procédés de dépôt comprennent une étape de masquage pour générer la structure non uniforme en épaisseur et conviennent pour toutes sortes d'OTC. Les procédés de gravure comprennent une étape de gravure chimique et conviennent particulièrement pour les TCO qui requièrent par ailleurs une étape de gravure pour générer une texturation (exemple : ZnO:Al par pulvérisation magnétron) pour les applications photovoltaïques.

Les procédés ici décrits sont relativement simples, mais ne sont pas nécessairement les seuls qui permettent de fabriquer des modules photovoltaïques conformes à l'invention.

L'invention permet une amélioration notable du rendement des modules photovoltaïques sans grande augmentation dans la complexité de ces modules et en appliquant les procédés de fabrication simples.

Une cellule d'un module photovoltaïque de l'invention n'utilise pas une couche uniforme de TCO, mais au contraire utilise les caractéristiques optimales d'une couche de TCO variables en fonction de la position de la couche et de la distance à l'interconnexion entre cellules.

## Revendications

1. Module photovoltaïque (1) comprenant au moins deux cellules photovoltaïques (7, 7') en série, chaque cellule (7, 7') étant de forme rectangulaire et comprenant respectivement :
- une électrode arrière en couche mince (5, 5'),
- un empilement photovoltaïque d'au moins deux matériaux actifs photovoltaïques (3, 3') compris entre l'électrode arrière (5, 5') et une électrode transparente conductrice (TC) en couche mince (4, 4'),
- ladite électrode TC (4, 4') étant apte à collecter et à transmettre un courant électrique (10, 10') généré par l'empilement photovoltaïque (3, 3'), et
les deux cellules photovoltaïques (7, 7') étant reliées électriquement en série par une bande de contact électrique (6) s'étendant le long d'un côté adjacent aux deux cellules (7, 7'), ladite bande de contact (6) étant comprise entre l'électrode TC (4) de la première cellule (7) et l'électrode arrière (5') de la seconde cellule (7'),
**caractérisé en ce que** :
l'épaisseur locale (e) de l'électrode transparente en couche mince (4) de la cellule (7) varie en fonction de la distance à ladite bande de contact électrique (6).

2. Module photovoltaïque (1) selon la revendication 1, **caractérisé en ce que** les propriétés optoélectroniques de l'électrode transparente en couche mince (4) varient en fonction de la distance à ladite bande de contact électrique (6).

3. Module photovoltaïque (1) selon l'une des revendications 1 ou 2, **caractérisé en ce que** l'épaisseur locale (e) et/ou les propriétés optoélectroniques de l'électrode transparente en couche mince (4) d'une cellule (7) décroîssent linéairement à partir de la bande de contact (6) suivant une direction (X) dans le plan de ladite électrode transparente en couche mince (4).

4. Module photovoltaïque (1) selon l'une des revendications 1 ou 2, **caractérisé en ce que** l'épaisseur locale (e) et/ou les propriétés optoélectroniques de l'électrode transparente en couche mince (4) d'une cellule (7) décroîssent de manière non linéaire à partir de la bande de contact (6) suivant une direction (X) dans le plan de ladite électrode transparente en couche mince (4).

5. Module photovoltaïque (1) selon l'une des revendications 1 à 4 **caractérisé en ce que** le matériau de l'électrode TC (4) est un oxyde transparent conducteur parmi l'oxyde d'étain dopé au fluor (SnO₂:F), l'oxyde de zinc dopé aluminium (ZnO:AI) ou un alliage d'oxydes métalliques (ITO).

6. Module photovoltaïque (1) selon l'une des revendications 1 à 5 **caractérisé en ce qu'**il comprend une série de cellules photovoltaïques (7, 7', 7"...) identiques déposées sur un même substrat (2), et **en ce que** l'empilement photovoltaïque de matériaux actifs (3, 3', 3"...) comprend du silicium amorphe (a-Si :H), dopé ou intrinsèque.

7. Procédé de fabrication d'un module photovoltaïque (1) selon l'une des revendications 1 à 6 comprenant une série de N cellules photovoltaïques (7, 7', 7"...) de formes rectangulaires de largeur L **caractérisé en ce que** la couche mince transparente conductrice (4, 4', 4"...) d'épaisseur variable est déposée sur un substrat par pulvérisation cathodique d'un matériau TC à travers un masque (8) comprenant N dents de scies de largeur L, tout en appliquant pendant la pulvérisation, une translation relative entre ledit masque et ledit substrat dans la direction (X) des dents de scie.

8. Procédé de fabrication d'un module photovoltaïque (1) selon l'une des revendications 1 à 6 comprenant une série de N cellules photovoltaïques (7, 7', 7"...) de largeurs L caractérisé en ce la couche mince transparente conductrice (4, 4', 4"...) d'épaisseur variable est déposée par pulvérisation cathodique d'un matériau TC à travers deux masques (9, 9') comprenant une série de N fentes de largeur L et N zones écran de largeur L, lesdits masques (9, 9') étant séquentiellement mobiles en translation dans deux directions opposées.

9. Procédé de fabrication d'un module photovoltaïque (1) selon l'une des revendications 1 à 6 comprenant une série de N cellules photovoltaïques (7, 7', 7"...) de formes rectangulaires de largeur L **caractérisé en ce que** la couche mince transparente conductrice (4, 4', 4"...) d'épaisseur variable est déposée sur un substrat (2) par décomposition thermique d'un précurseur gazeux à travers un masque (8) comprenant N dents de scies de largeur L, tout en appliquant pendant la décomposition thermique, une translation relative entre ledit masque et ledit substrat dans la direction (X) des dents de scie.

10. Procédé de fabrication d'un module photovoltaïque (1) selon l'une des revendications 1 à 6 **caractérisé en ce qu'**il comprend une étape de dépôt uniforme d'une couche mince transparente conductrice (TC) et une étape de gravure chimique en phase liquide de ladite couche mince TC par application de ladite couche uniforme sur le bord (14) supérieur d'une cuve (12) comprenant N bacs (13, 13', 13", 13"") de gravure et pour chaque bac des moyens de remplissage (15) et de vidange (16) d'un liquide (18) apte à graver le matériau transparent conducteur et des moyens d'étanchéité entre chaque bac, ledit bord supérieur (14) formant un plan incliné par rapport au niveau horizontal du liquide dans lesdits bacs (13, 13', 13", 13"") de manière à ce que le remplissage et la vidange progressive des bacs est apte à graver de manière non uniforme la couche transparente conductrice (4).

11. Procédé de fabrication d'un module photovoltaïque (1) selon l'une des revendications 1 à 6 **caractérisé en ce qu'**il comprend une étape de dépôt uniforme d'une couche mince transparente conductrice et une étape de gravure chimique en phase liquide de ladite couche mince par application de ladite couche uniforme sur le bord (14) supérieur d'une cuve (12') comprenant N bacs de gravure (13, 13', 13", 13"") comprenant des moyens communs de remplissage (15) et de vidange (16) d'un liquide (18) apte à graver le matériau transparent conducteur et des moyens d'échappement (17) de l'air de chaque bac, ledit bord supérieur (14) formant un plan incliné par rapport au niveau horizontal du liquide (18) dans lesdits bacs (13, 13', 13", 13"") de manière à ce que l'échappement (17) progressif de l'air desdits bacs est apte à graver de manière non uniforme la couche transparente conductrice (4).

12. Procédé de fabrication d'un module photovoltaïque (1) selon l'une des revendications 1 à 6 **caractérisé en ce qu'**il comprend une étape de dépôt d'une couche mince transparente conductrice et une étape d'exposition sélective de certaines zones de ladite couche mince transparente conductrice à un faisceau lumineux intense, tel qu'un faisceau laser, comprenant au moins une longueur d'onde absorbée par ladite couche mince transparente conductrice, la durée d'exposition et/ou de l'intensité locale du faisceau laser étant variables en fonction de la distance à la bande de contact électrique (6) s'étendant le long d'un côté adjacent à deux cellules (7, 7') en série de manière à obtenir une couche TC de propriétés opto-électroniques variables en fonction de la distance à ladite bande de contact électrique (6).

13. Procédé de fabrication d'un module photovoltaïque (1) selon la revendication 12 **caractérisé en ce qu'**il comprend en outre une étape de dépôt d'une couche supplémentaire adjacente à la couche mince transparente conductrice et une étape d'exposition de ladite couche adjacente à un faisceau lumineux intense, tel qu'un faisceau laser, comprenant au moins une longueur d'onde absorbée par ladite couche adjacente de manière à transférer l'énergie absorbée par la couche adjacente à ladite couche mince transparente conductrice (4).

## Patentansprüche

1. Photovoltaikmodul (1) mit wenigstens zwei in Reihe geschalteten Photovoltaikzellen (7, 7'), wobei jede Zelle (7, 7') rechteckig ist und jeweils
- eine hintere Dünnschichtelektrode (5, 5'),
- eine photovoltaische Aufschichtung von wenigstens zwei zwischen der hinteren Elektrode (5, 5') und einer durchsichtigen leitenden Elektrode (TC) in Dünnschicht (4, 4') angeordneten photovoltaischen aktiven Materialien (3, 3') aufweist,
- wobei die Elektrode TC (4, 4') dazu ausgelegt ist, einen durch die photovoltaische Aufschichtung (3, 3') erzeugten elektrischen Strom (10, 10') zu sammeln und zu übermitteln, und
die beiden Photovoltaikzellen (7, 7') durch ein elektrisches Kontaktband (6), das sich entlang einer zu den beiden Zellen (7, 7') benachbarten Seite erstreckt, elektrisch in Reihe verbunden sind, wobei das Kontaktband (6) zwischen der Elektrode TC (4) der ersten Zelle (7) und der hinteren Elektrode (5') der zweiten Zelle (7') enthalten ist,
**dadurch gekennzeichnet, daß**
die lokale Dicke (e) der durchsichtigen Elektrode in Dünnschicht (4) der Zelle (7) in Abhängigkeit vom Abstand zum elektrischen Kontaktband (6) variiert.

2. Photovoltaikmodul (1) gemäß Anspruch 1, **dadurch gekennzeichnet, daß** die optoelektronischen Eigenschaften der durchsichtigen Elektrode in Dünnschicht (4) in Abhängigkeit vom Abstand zum elektrischen Kontaktband (6) variieren.

3. Photovoltaikmodul (1) gemäß einem der Ansprüche 1 oder 2, **dadurch gekennzeichnet, daß** die lokale Dicke (e) und/oder die optoelektronischen Eigenschaften der durchsichtigen Elektrode in Dünnschicht (4) einer Zelle (7) vom elektrischen Kontaktband (6) aus in einer Richtung (X) in der Ebene der durchsichtigen Elektrode in Dünnschicht (4) linear abnehmen.

4. Photovoltaikmodul (1) gemäß einem der Ansprüche 1 oder 2, **dadurch gekennzeichnet, daß** die lokale Dicke (e) und/oder die optoelektronischen Eigenschaften der durchsichtigen Elektrode in Dünnschicht (4) einer Zelle (7) vom elektrischen Kontaktband (6) aus in einer Richtung (X) in der Ebene der durchsichtigen Elektrode in Dünnschicht (4) nichtlinear abnehmen.

5. Photovoltaikmodul (1) gemäß einem der Ansprüche 1 bis 4, **dadurch gekennzeichnet, daß** das Material der Elektrode TC (4) ein durchsichtiges leitendes Oxid, und zwar mit Fluor dotiertes Zinnoxid (SnO2:F) oder mit Aluminium dotiertes Zinkoxid (ZnO:Al), oder eine Legierung von metallischen Oxiden (ITO) ist.

6. Photovoltaikmodul (1) gemäß einem der Ansprüche 1 bis 5, **dadurch gekennzeichnet, daß** es eine Reihe von auf einem selben Substrat aufgebrachten identischen Photovoltaikzellen (7, 7', 7", ...) aufweist und daß die photovoltaische Aufschichtung von aktiven Materialien (3, 3', 3", ...) dotiertes oder inhärentes amorphes Silizium (a-Si:H) aufweist.

7. Verfahren zum Herstellen eines Photovoltaikmoduls (1) gemäß einem der Ansprüche 1 bis 6, das eine Reihe von N rechteckigen Photovoltaikzellen (7, 7', 7", ...) der Breite L aufweist, **dadurch gekennzeichnet, daß** die durchsichtige leitende Dünnschicht (4, 4', 4", ...) variabler Dicke durch kathodische Zerstäubung eines TC-Materials durch eine Maske (8) mit N Sägezähnen der Breite L hindurch auf ein Substrat aufgebracht wird, wobei während der Zerstäubung eine relative Translation zwischen der Maske und dem Substrat in der Richtung (X) der Sägezähne bewirkt wird.

8. Verfahren zum Herstellen eines Photovoltaikmoduls (1) gemäß einem der Ansprüche 1 bis 6, das eine Reihe von N Photovoltaikzellen (7, 7', 7", ...) der Breite L aufweist, **dadurch gekennzeichnet, daß** die durchsichtige leitende Dünnschicht (4, 4', 4", ...) variabler Dicke durch kathodische Zerstäubung eines TC-Materials durch zwei Masken (9, 9') hindurch, die eine Reihe von N Spalten der Breite L und N Abschirmzonen der Breite L aufweisen, aufgebracht wird, wobei die Masken (9, 9') in zwei entgegengesetzten Richtungen sequentiell translatorisch beweglich sind

9. Verfahren zum Herstellen eines Photovoltaikmoduls (1) gemäß einem der Ansprüche 1 bis 6, das eine Reihe von N rechteckigen Photovoltaikzellen (7, 7', 7", ...) der Breite L aufweist, **dadurch gekennzeichnet, daß** die durchsichtige leitende Dünnschicht (4, 4', 4", ...) variabler Dicke durch thermische Zersetzung eines gasförmigen Vorläufermaterials durch eine Maske (8) mit N Sägezähnen der Breite L hindurch auf ein Substrat (2) aufgebracht wird, wobei während der thermischen Zersetzung eine relative Translation zwischen der Maske und dem Substrat in der Richtung (X) der Sägezähne bewirkt wird.

10. Verfahren zum Herstellen eines Photovoltaikmoduls (1) gemäß einem der Ansprüche 1 bis 6, **dadurch gekennzeichnet, daß** es einen Schritt des gleichmäßigen Aufbringens einer durchsichtigen leitenden Dünnschicht (TC) und einen Schritt der chemischen Ätzung in flüssiger Phase der Dünnschicht TC durch Aufbringen der gleichmäßigen Schicht auf den oberen Rand (14) eines Behälters (12), der N Ätznäpfe (13, 13', 13", 13"") und für jeden Napf Mittel zum Befüllen (15) mit und Mittel zum Entleeren (16) einer zum Ätzen des durchsichtigen leitenden Materials geeigneten Flüssigkeit (18) sowie Dichtmittel zwischen jedem Napf aufweist, aufweist, wobei der obere Rand (14) eine in Bezug auf das horizontale Niveau der Flüssigkeit in den Näpfen (13, 13', 13", 13"") schräge Ebene bildet, so daß das progressive Befüllen und Entleeren der Näpfe geeignet ist, die durchsichtige leitende Schicht (4) in ungleichmäßiger Weise zu ätzen.

11. Verfahren zum Herstellen eines Photovoltaikmoduls (1) gemäß einem der Ansprüche 1 bis 6, **dadurch gekennzeichnet, daß** es einen Schritt des gleichmäßigen Aufbringens einer durchsichtigen leitenden Dünnschicht und einen Schritt der chemischen Ätzung in flüssiger Phase der Dünnschicht durch Aufbringen der gleichmäßigen Schicht auf den oberen Rand (14) eines Behälters (12'), der N Ätznäpfe (13, 13', 13", 13""), die gemeinsame Mittel zum Befüllen (15) mit und gemeinsame Mittel zum Entleeren (16) einer zum Ätzen des durchsichtigen leitenden Materials geeigneten Flüssigkeit (18) sowie Mittel (17), um die Luft aus jedem Napf entweichen zu lassen, aufweist, aufweist, wobei der obere Rand (14) eine in Bezug auf das horizontale Niveau der Flüssigkeit (18) in den Näpfen (13, 13', 13", 13"") schräge Ebene bildet, so daß das progressive Entweichen (17) der Luft aus den Näpfen geeignet ist, die durchsichtige leitende Schicht (4) in ungleichmäßiger Weise zu ätzen.

12. Verfahren zum Herstellen eines Photovoltaikmoduls (1) gemäß einem der Ansprüche 1 bis 6, **dadurch gekennzeichnet, daß** es einen Schritt des Aufbringens einer durchsichtigen leitenden Dünnschicht und einen Schritt, gewisse Zonen der durchsichtigen leitenden Dünnschicht einem intensiven Lichtstrahl, wie zum Beispiel einem Laserstrahl, auszusetzen, der wenigstens eine von der durchsichtigen leitenden Dünnschicht absorbierte Wellenlänge aufweist, aufweist, wobei die Belichtungsdauer und/oder die örtliche Stärke des Laserstrahls in Abhängigkeit von der Entfernung zum sich entlang einer an den beiden in Reihe liegenden Zellen (7, 7') anliegenden Seite erstreckenden elektrischen Kontaktband (6) veränderbar sind, um eine TC-Schicht mit in Abhängigkeit von der Entfernung zum elektrischen Kontaktband (6) veränderbaren optoelektronischen Eigenschaften zu erhalten.

13. Verfahren zum Herstellen eines Photovoltaikmoduls (1) gemäß Anspruch 12, **dadurch gekennzeichnet, daß** es außerdem einen Schritt des Aufbringens einer zusätzlichen, an der durchsichtigen leitenden Dünnschicht anliegenden Schicht und einen Schritt, die zusätzliche Schicht einem intensiven Lichtstrahl, wie zum Beispiel einem Laserstrahl, auszusetzen, der wenigstens eine von der durchsichtigen leitenden Dünnschicht absorbierte Wellenlänge aufweist, um die von der anliegenden Schicht absorbierte Energie auf die durchsichtige leitende Dünnschicht zu übertragen, aufweist.

## Claims

1. A photovoltaic module (1) comprising at least two photovoltaic cells (7, 7') in series, each cell (7, 7') being rectangular in shape and comprising, respectively:
- a thin-layer back electrode (5, 5'),
- a photovoltaic stack of at least two photovoltaic active materials (3, 3') comprised between the back electrode (5, 5') and a thin-layer transparent conductive (TC) electrode (4, 4');
- said TC electrode (4, 4') being capable of collecting and transmitting an electric current (10, 10') generated by the photovoltaic stack (3, 3'), and
the two photovoltaic cells (7, 7') being electrically connected in series by an electric contact strip (6) running along a side adjacent to the two cells (7, 7'), said contact strip (6) being comprised between the TC electrode (4) of the first cell (7) and the back electrode (5') of the second cell (7'),
**characterized in that**:
the local thickness (e) of the thin-layer transparent electrode (4) of the cell (7) varies as a function of the distance to said electric contact strip (6).

2. A photovoltaic module (1) according to claim 1, **characterized in that** the optoelectronic properties of the thin-layer transparent electrode (4) vary as a function of the distance to said electric contact strip (6).

3. A photovoltaic module (1) according to one of claims 1 or 2, **characterized in that** the local thickness (e) and/or the optoelectronic properties of the thin-layer transparent electrode (4) of a cell (7) decrease linearly from the contact strip (6), according to one direction (X) in the plane of said thin-layer transparent electrode (4).

4. A photovoltaic module (1) according to one of claims 1 or 2, **characterized in that** the local thickness (e) and/or the optoelectronic properties of the thin-layer transparent electrode (4) of a cell (7) decrease non-linearly from the contact strip (6), according to one direction (X) in the plane of said thin-layer transparent electrode (4).

5. A photovoltaic module (1) according to one of claims 1 to 4, **characterized in that** the material of the TC electrode (4) is a transparent conductive oxide selected from the fluorine-doped tin oxide (SnO₂:F), the aluminium-doped zinc oxide (ZnO:AI), or metal oxide alloy (ITO).

6. A photovoltaic module (1) according to one of claims 1 to 5, **characterized in that** it comprises a series of identical photovoltaic cells (7, 7', 7"...) deposited onto a same substrate (2), and **in that** the photovoltaic stack of active materials (3, 3', 3"...) comprises doped or intrinsic amorphous silicon (a-Si:H).

7. A method for manufacturing a photovoltaic module (1) according to one of claims 1 to 6, comprising a series of N rectangular photovoltaic cells (7, 7', 7"...) of width L, **characterized in that** the thin transparent conductive layer (4, 4', 4"...) of variable thickness is deposited onto a substrate by cathode sputtering of a TC material through a mask (8) comprising N saw-teeth of width L, while applying, during the sputtering, a relative translation between said mask and said substrate in the direction (X) of the saw-teeth.

8. A method for manufacturing a photovoltaic module (1) according to one of claims 1 to 6, comprising a series of N photovoltaic cells (7, 7', 7"...) of width L, **characterized in that** the thin transparent conductive layer (4, 4', 4"...) of variable thickness is deposited by cathode sputtering of a TC material through two masks (9, 9') comprising a series of N slots of width L and N shield areas of width L, said masks (9, 9') being sequentially movable in translation in two opposite directions.

9. A method for manufacturing a photovoltaic module (1) according to one of claims 1 to 6, comprising a series of N rectangular photovoltaic cells (7, 7', 7"...) of width L, **characterized in that** the thin transparent conductive layer (4, 4', 4"...) of variable thickness is deposited onto a substrate (2) by thermal decomposition of a gas precursor through a mask (8) comprising N saw-teeth of width L, while applying, during the thermal decomposition, a relative translation between said mask and said substrate in the direction (X) of the saw teeth.

10. A method for manufacturing a photovoltaic module (1) according to one of claims 1 to 6, **characterized in that** it comprises a step of uniformly depositing a thin transparent conductive (TC) layer and a step of liquid chemical etching said thin TC layer by applying said uniform layer to the upper edge (14) of a vessel (12) comprising N etching tanks (13, 13', 13", 13"') and, for each tank, means for the filling (15) and the draining (16) of a liquid (18) capable of etching the transparent conductive material and sealing means between each tank, said upper edge (14) forming a plane inclined with respect to the horizontal level of the liquid in said tanks (13, 13', 13", 13"'), so that the filling and the progressive draining of the tanks are capable of non-uniformly etching the transparent conductive layer (4).

11. A method for manufacturing a photovoltaic module (1) according to one of claims 1 to 6, **characterized in that** it comprises a step of uniformly depositing a thin transparent conductive layer and a step of liquid chemical etching said thin layer by applying said uniform layer to the upper edge (14) of a vessel (12') comprising N etching tanks (13, 13', 13", 13"') comprising common means for the filling (15) and the draining (16) of a liquid (18) capable of etching the transparent conductive material and means (17) for venting the air from each tank, said upper edge (14) forming a plane inclined with respect to the horizontal level of the liquid (18) in said tanks (13, 13', 13", 13"'), so that the progressive venting (17) of the air from said tanks is capable of non-uniformly etching the transparent conductive layer (4).

12. A method for manufacturing a photovoltaic module (1) according to one of claims 1 to 6, **characterized in that** it comprises a step of depositing a thin transparent conductive layer and a step of selective exposure of certain areas of said thin transparent conductive layer to an intense light beam, such as a laser beam, comprising at least one wavelength absorbed by said thin transparent conductive layer, the duration of exposure and/or the local intensity of the laser beam being variable as a function of the distance to the electric contact strip (6) extending along a side adjacent to the two cells (7, 7') in series so as to obtain a TC layer of variable opto-electronic properties as a function of the distance to said electric contact strip (6).

13. A method for manufacturing a photovoltaic module (1) according to claim 12, **characterized in that** it further comprises a step of depositing an additional layer adjacent to the thin transparent conductive layer and a step of exposing said adjacent layer to an intense light beam, such as a laser beam, comprising at least one wavelength absorbed by said adjacent layer, so as to transfer the energy absorbed by the adjacent layer to said thin transparent conductive layer (4).
